# EUROPEAN PATENT APPLICATION

(11) **EP 3 731 219 A1**
(43) Date of publication of application: **28.10.2020**
(21) Application number: 19832824.7
(22) Date of filing: 13.03.2019
(51) Int. Cl.: G09F 9/40, G09F 9/33, G09F 9/30, G09F 9/302

(54) **VIDEO DISPLAY DEVICE AND MULTI-DISPLAY SYSTEM**

(71) Applicant: Mitsubishi Electric Corporation, Tokyo 100-8310 (JP)
(72) Inventor: KAMIIKE, Tokumo, Tokyo 1008310 (JP)
(74) Representative: Pfenning, Meinig & Partner mbB
(86) International application number: PCT/JP2019/010272
(87) International publication number: WO 2020/183650

(57) **Abstract**

It is an object to provide technology enabling suppression of a level difference between display surfaces of a video display device and suppression of detachment of a video display module from a housing frame in a multi-display system. In a video display device 100, an adjustment unit includes an adjustment screw 20 including: a non-threaded portion 21 on a side of an LED display module 1000; a threaded portion 22 to be screwed into a housing frame 5; and an adjustment screw magnet 24 disposed at an end portion of the non-threaded portion 21 on the side of the LED display module 1000 and having a plurality of magnetic poles different in a rotational direction. A fixing unit includes: a cylindrical part 12 having a through hole 13 into which the non-threaded portion 21 of the adjustment screw 20 is to be inserted and a slit 17 to be closed to reduce an inside diameter of the through hole 13 so that the non-threaded portion 21 is tightened by the through hole 13; and a fixing screw 11 closing the slit 17 to fix a location of the adjustment screw 20 in a front-back direction. The adjustment unit and the fixing unit are coaxially arranged.

## Description

### Technical Field

The present invention relates to adjustment of a level difference between display surfaces of display modules of a video display device included in a multi-display system.

### Background Art

A multi display system including video display devices in which a plurality of display elements, such as light emitting diodes (LEDs), are arranged to constitute a large screen is often used, for example, for outdoor and indoor advertisement display owing to improvement in performance and reduction in cost of the display elements. Such a multi-display system including video display devices has been used, for example, for display of moving images of natural images and animations. Furthermore, a viewing distance is reduced by arranging smaller display elements at a higher density to make a pixel pitch narrower. A multi-display system including video display devices has thus been used for display of output images from information processing apparatuses in meeting rooms and for monitoring applications. Especially for monitoring applications, the multi-display system often displays almost still images.

In the multi-display system including video display devices, use of surface mount device (SMD)-type video display devices is predominant in which small LED display modules formed by mounting LED display elements in cavities molded using ceramic or resin, and sealing the LED display elements with a sealing resin are mounted on substrates.

Conventional SMD-type video display devices have been used mainly in a large multi-display system located outdoors or in a commercial facility as they have pixel pitches of 3 mm or more. In recent years, a multi-display system including a plurality of tiled video display devices in which LED display modules including densely mounted elements having pixel pitches of 1 mm or more and 2 mm or less are arranged has been introduced into the market against a backdrop of reduction in cost and an increase in definition of the LED display elements.

In such a multi-display system in which video display devices including densely mounted LED display elements are arranged, video quality is greatly affected by evenness of planes of display surfaces. A method of holding and fixing the LED display modules is thus important. For example, Patent Document 1 discloses a method of holding and fixing a video display device.

### Prior Art Document

### Patent Document

Patent Document 1: Japanese Unexamined Patent Application Publication (Translation of PCT application) No. 2018-506748

### Summary

### Problem to be Solved by the Invention

In a video display device in which a plurality of display bodies each having a display surface of a predetermined size are arranged, it is necessary to suppress a level difference in a front-back direction between display surfaces.

Patent Document 1 discloses a method of holding a display panel (corresponding to a video display module) and a method of adjusting a level difference between display surfaces. The display panel, however, is fixed to a holding carrier (corresponding to a housing frame) for holding the display panel only by a force of attraction of a magnet, and can be detached from the holding carrier upon receiving an external force, such as a shock, greater than the force of attraction.

It is thus an object of the present invention to provide technology enabling suppression of a level difference between display surfaces of a video display device and suppression of detachment of a video display module from a housing frame in a multi-display system.

### Means to Solve the Problem

A video display device according to the present invention is a video display device including: a video display module in which display elements are arranged; a housing frame to which the video display module is to be fixed; an adjustment unit adjusting a location of the video display module in a front-back direction in a state of the video display module being temporarily fixed to the housing frame; a fixing unit fixing, to the housing frame, the video display module temporarily fixed to the housing frame, wherein the adjustment unit includes an adjustment screw including: a non-threaded portion on a side of the video display module; a threaded portion to be screwed into the housing frame; and a first magnet disposed at an end portion of the non-threaded portion on the side of the video display module and having a plurality of magnetic poles different in a rotational direction, the fixing unit is fixed to the video display module, the fixing unit includes: a cylindrical part having: a through hole into which the non-threaded portion of the adjustment screw is to be inserted; and a slit to be closed to reduce an inside diameter of the through hole so that the non-threaded portion is tightened by the through hole; and a fixing screw closing the slit to fix a location of the adjustment screw in the front-back direction, and the adjustment unit and the fixing unit are coaxially arranged.

### Effects of the Invention

According to the present invention, a level difference between display surfaces of a video display device can be suppressed, and detachment of a video display module from a housing frame can be suppressed.

The objects, features, aspects, and advantages of the present invention will become more apparent from the following detailed description and the accompanying drawings.

### Brief Description of Drawings

FIG. 1 is a perspective view illustrating a schematic configuration of a multi-display system according to Embodiment 1.
FIG. 2 is a perspective view illustrating a schematic configuration of a video display device according to Embodiment 1.
FIG. 3 is an exploded perspective view illustrating a configuration on a side of a back surface of the video display device.
FIG. 4 is a perspective view illustrating a configuration of a fixing slit collar of the video display device.
FIG. 5 is a perspective view illustrating a configuration of a fixing screw of the fixing slit collar.
FIG. 6 is a sectional view illustrating a configuration of an adjustment unit and a fixing unit of the video display device.
FIG. 7 is a sectional view for explaining a method of adjusting and fixing a location of an LED display module of the video display device in a front-back direction.
FIG. 8 is a sectional view for explaining magnetic fields acting when the location of the LED display module in the front-back direction is adjusted and fixed.
FIG. 9 is a perspective view illustrating a configuration of a fixing slit collar of a video display device according to Embodiment 2.
FIG. 10 is a perspective view illustrating a configuration of a fixing screw of the fixing slit collar.
FIG. 11 is a sectional view for explaining a method of adjusting and fixing the location of the LED display module of the video display device in the front-back direction.
FIG. 12 illustrates a configuration of a magnet coupling formed by a fixing screw magnet of a fixing tool and a fixing magnet of the fixing screw of the video display device.

### Description of Embodiments

### <Embodiment 1>

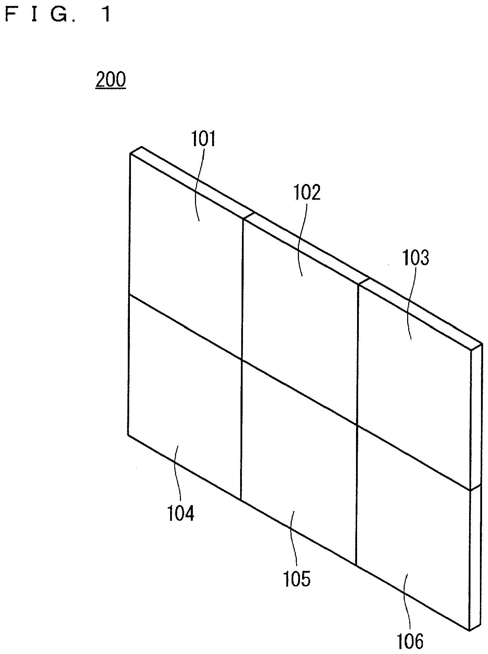

Embodiment 1 of the present invention will be described below with use of the drawings. FIG. 1 is a perspective view illustrating a schematic configuration of a multi-display system 200 according to Embodiment 1.

As illustrated in FIG. 1, the multi-display system 200 includes a plurality of video display devices 101 to 106 for image display arranged in a matrix. In Embodiment 1, the video display devices 101 to 106 are each described as a video display device 100 when not being distinguished from one another.

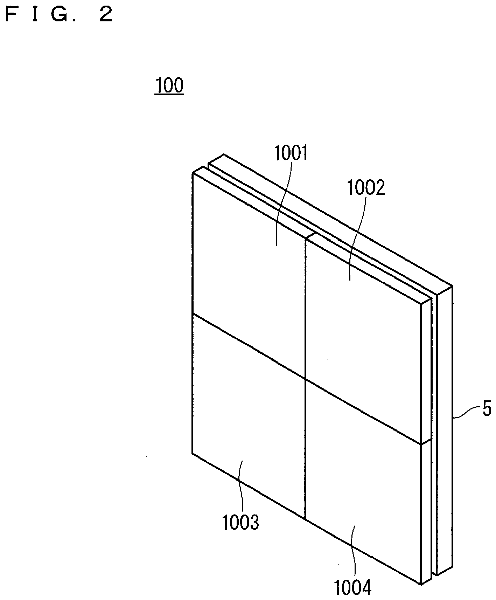

FIG. 2 is a perspective view illustrating a schematic configuration of the video display device 100. As illustrated in FIG. 2, the video display device 100 includes four LED display modules 1001 to 1004 as video display modules and a housing frame 5. The housing frame 5 is a frame for holding the LED display modules 1001 to 1004. The LED display modules 1001 to 1004 are each described below as an LED display module 1000 when not being distinguished from one another. In the LED display module 1000, a plurality of light emitting elements, such as LED elements, are arranged.

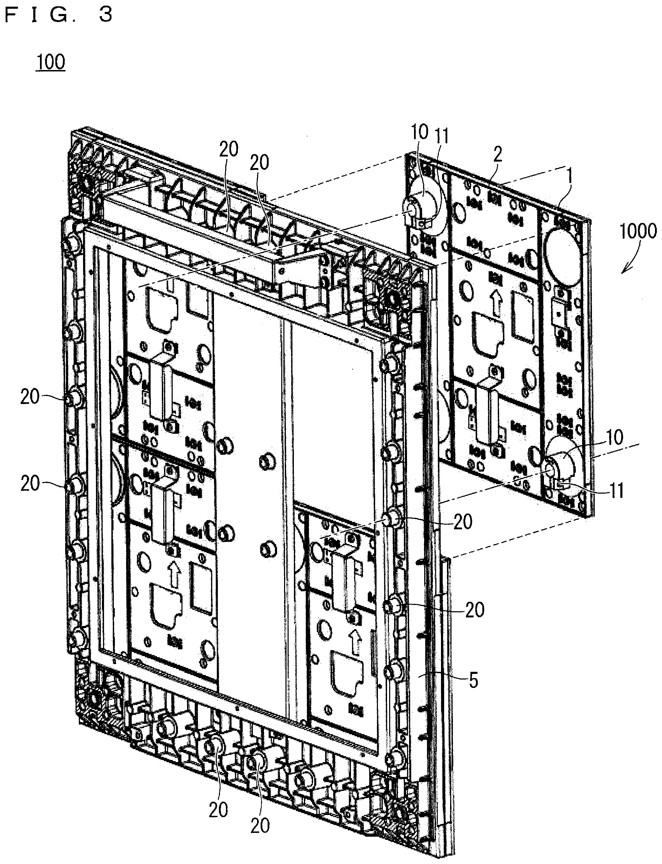

FIG. 3 is an exploded perspective view illustrating a configuration on a side of a back surface of the video display device 100. Specifically, FIG. 3 is a perspective view illustrating the configuration on the side of the back surface of the video display device 100 in a state of one of the LED display modules 1000 being removed from the housing frame 5.

As illustrated in FIG. 3, the video display device 100 includes the LED display modules 1000, a plurality of fixing slit collars 10, a plurality of adjustment screws 20, and the other mechanical parts. Each of the LED display modules 1000 includes an LED substrate 1 on which LED elements as display elements are arranged, a mold base 2 holing the LED substrate 1, and the other mechanical parts.

Each of the adjustment screws 20 is attached in advance to the housing frame 5, and temporarily fixes the LED display module 1000 to the housing frame 5. The adjustment screw 20 is rotated in this state to move the LED display module 1000 temporarily fixed by the adjustment screw 20 in a front-back direction so that a location of a display surface of the LED display module 1000 in the front-back direction is adjusted. Adjustment described above allows for suppression of a level difference in the front-back direction between display surfaces of the LED display modules 1001 to 1004 of the video display device 100. The adjustment screws 20 herein constitute an adjustment unit adjusting the location of the LED display module 1000 in the front-back direction in a state of the LED display module 1000 being temporarily fixed to the housing frame 5.

Each of the fixing slit collars 10 is attached in advance to a back surface of the mold base 2, permanently fixes, to the housing frame 5, the LED display module 1000 temporarily fixed to the housing frame 5, and, further, fixes the LED display module 1000 having the display surface whose location in the front-back direction has been adjusted by the adjustment screws 20. A fixing screw 11 included in the fixing slit collar 10 is rotated forward, so that the fixing slit collar 10 fixes the adjustment screw 20. A rotational axis of the adjustment screw 20 and a fixing axis of the fixing slit collar 10 for fixing the adjustment screw 20 are coaxially arranged. The fixing slit collars 10 herein constitute a fixing unit fixing, to the housing frame 5, the LED display module 1000 temporarily fixed to the housing frame 5.

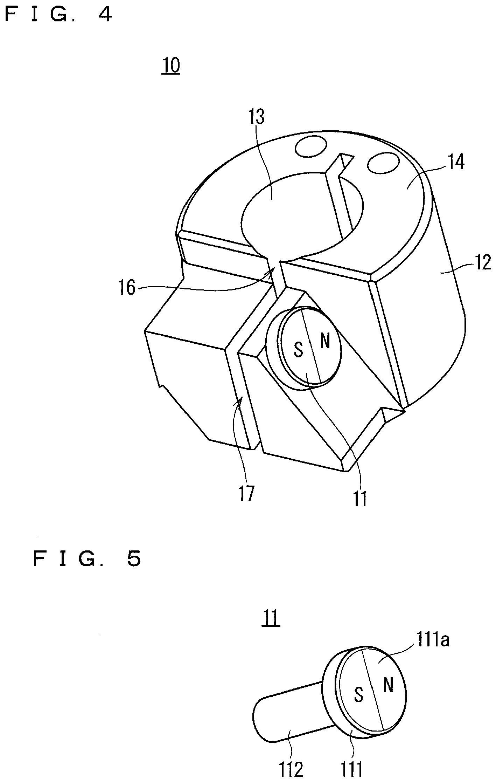

FIG. 4 is a perspective view illustrating a configuration of the fixing slit collar 10. The fixing slit collar 10 includes a cylindrical part 12 and a fixing screw 11. The cylindrical part 12 includes a substantially cylindrical portion having a shape of a cylinder partially cut out in a direction of extension and a block portion provided to a cutting surface of the substantially cylindrical portion. The block portion has a slit 17 extending parallel to the direction of extension of the substantially cylindrical portion. The fixing screw 11 is mounted on the block portion to cross the slit 17.

The substantially cylindrical portion has, at a center portion thereof, a through hole 13 extending in the direction of extension. The fixing slit collar 10 is attached in advance to the mold base 2 so that the through hole 13 is coaxial with the adjustment screw 20. The through hole 13 has an inside diameter slightly greater than an outside diameter of the adjustment screw 20, so that the adjustment screw 20 can slide inside the through hole 13 in the direction of extension of the cylindrical part 12, that is to say, in the front-back direction.

A portion of the substantially cylindrical portion connected to the block portion has a slit 16 extending along the direction of extension of the cylindrical part 12 to partially remove a circumferential wall of the through hole 13. The slit 16 of the substantially cylindrical portion communicates with the slit 17 of the block portion. The fixing screw 11 of the fixing slit collar 10 is rotated forward to close the slit 17, and, with the closure of the slit 17, the slit 16 of the substantially cylindrical portion is closed to reduce the inside diameter of the through hole 13. The through hole 13 having the reduced inside diameter tightens the adjustment screw 20 to fix the adjustment screw 20 to the fixing slit collar 10.

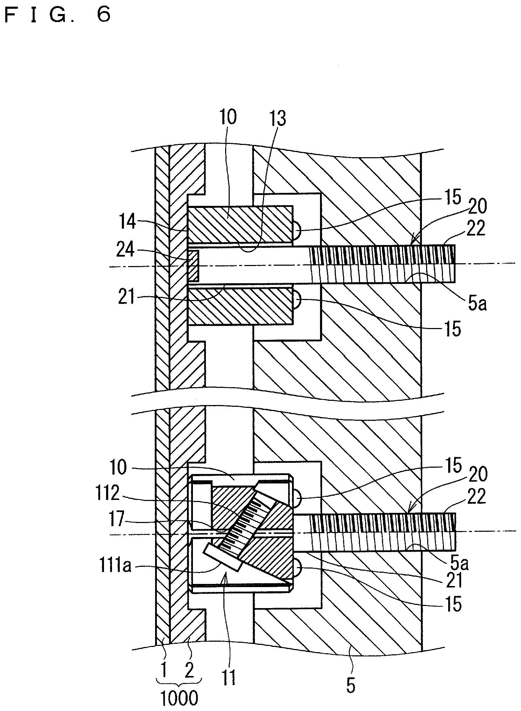

A front surface of the substantially cylindrical portion of the fixing slit collar 10 has a mounting surface 14, and the mounting surface 14 is brought into contact with the back surface of the mold base 2 in advance. The fixing slit collar 10 is fixed to the mold base 2 by screws 15 (see FIG. 6) in a state of the mounting surface 14 being brought into contact with the mold base 2. The fixing slit collar 10 may be adhesively fixed or press fitted to the mold base 2 instead of being fixed by the screws.

FIG. 5 is a perspective view illustrating a configuration of the fixing screw 11 of the fixing slit collar 10. As illustrated in FIG. 5, the fixing screw 11 includes a head 111, a threaded portion 112 for closing the slit 17, and a fixing screw magnet 111a as a second magnet. The fixing screw magnet 111a is disposed on a top surface of the head 111, and has a plurality of magnetic poles different in a rotational direction of the fixing screw 11.

FIG. 6 is a sectional view illustrating a configuration of the adjustment unit and the fixing unit. The adjustment screw 20 includes a cylindrical non-threaded portion 21 on a side of the LED display module 1000, a threaded portion 22, and an adjustment screw magnet 24 as a first magnet. The non-threaded portion 21 is located to be closer to the LED display module 1000 than the threaded portion 22 is, and has a recess at an end portion on the side of the LED display module 1000. The adjustment screw magnet 24 is embedded in the recess of the non-threaded portion 21. The adjustment screw magnet 24 is brought into contact with the back surface of the mold base 2 made of a magnetic material, and temporarily fixes the adjustment screw 20 to the mold base 2 by a force of attraction of the adjustment screw magnet 24. Although the mold base 2 is described to be made of the magnetic material, a contact part made of a magnetic material to be coupled to the mold base 2 may be embedded between the mold base 2 made of a non-magnetic material and the adjustment screw magnet 24 instead.

The force of attraction generated by a magnetic force of the adjustment screw magnet 24 is herein set to be strong enough to be able to fasten the LED display module 1000 at a mounting location of the housing frame 5 with a plurality of adjustment screws 20 used for a single LED display module 1000. The adjustment screw magnet 24 of the adjustment screw 20 can thereby temporarily fix the LED display module 1000 to the housing frame 5. The adjustment screw magnet 24 includes one or more magnets.

The threaded portion 22 has an external thread, and is screwed into a threaded hole 5a of the housing frame 5. The non-threaded portion 21 is disposed to be coaxial with the through hole 13 of the fixing slit collar 10. Once the fixing screw 11 is rotated forward, the inside diameter of the through hole 13 is reduced, and the non-threaded portion 21 is tightened by the circumferential wall of the through hole 13, so that the adjustment screw 20 is fixed to the fixing slit collar 10. The LED display module 1000 can thereby be fixed to the housing frame 5.

The non-threaded portion 21 may have a non-cylindrical shape, such as a polygonal prism shape. In a state of the fixing slit collar 10 tightening the non-threaded portion 21 of the adjustment screw 20, rotation of the adjustment screw 20 is suppressed only by a frictional force between the non-threaded portion 21 and the circumferential wall of the through hole 13 in a case where the non-threaded portion 21 is cylindrical. In a case where the non-threaded portion 21 is polygonal, however, a catching force of external corners of the non-threaded portion 21 is added to the frictional force to further suppress a rotational force of the adjustment screw 20.

As described above, even if an unexpected external force greater than the force of attraction generate by the magnetic force of the adjustment screw magnet 24 is applied, for example, by an earthquake as a force to tear the LED display module 1000 from the housing frame 5, a risk of displacement and releasing fixing of the LED display module 1000 and the like can be suppressed by fixing the LED display module 1000 to the housing frame 5 using the fixing slit collar 10.

Furthermore, movement of the adjustment screw 20 relative to the housing frame 5, that is to say, movement of the display surface of the LED display module 1000 in the front-back direction can be suppressed by suppressing rotation of the adjustment screw 20 using the fixing slit collar 10.

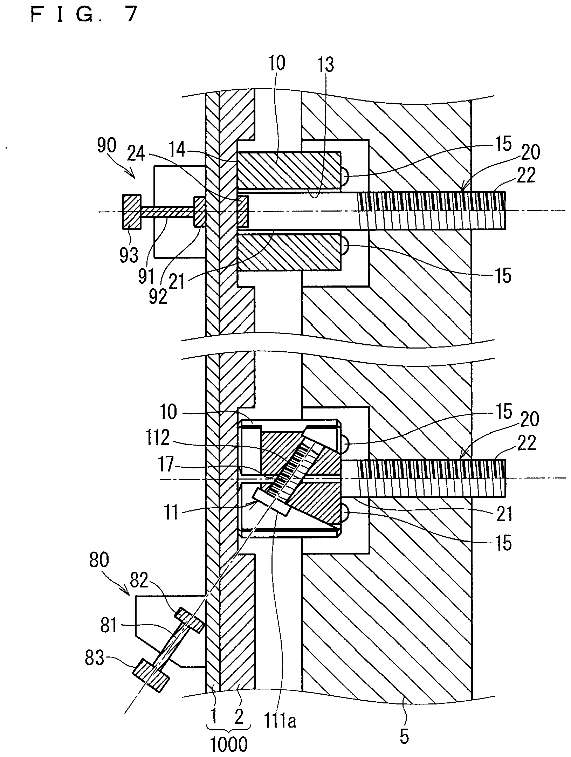

A method of adjusting and fixing the location of the LED display module 1000 in the front-back direction will be described next. FIG. 7 is a sectional view for explaining the method of adjusting and fixing the location of the LED display module 1000 in the front-back direction.

As illustrated in FIG. 7, an adjustment tool 90 of the video display device 100 is used to adjust the location of the LED display module 1000 in the front-back direction from a side of the display surface in a state of the mold base 2 made of the magnetic material being attracted by the adjustment screw magnet 24, that is to say, in a state of the LED display module 1000 being temporarily fixed to the housing frame 5.

The adjustment tool 90 includes an adjustment magnet 92 as a third magnet similar to the adjustment screw magnet 24 disposed at a leading end portion of the adjustment screw 20. The adjustment magnet 92 and the adjustment screw magnet 24 oppose each other to allow a magnetic force to act to attract each other to form a first magnet coupling. The adjustment magnet 92 is rotated about an adjustment shaft 91 in a state of the adjustment magnet 92 and the adjustment screw magnet 24 attracting each other to generate a rotational force of the adjustment screw 20 including the adjustment screw magnet 24 to thereby cause the adjustment screw 20 to move in the front-back direction based on the threaded portion 22 screwed into the housing frame 5. With the movement of the adjustment screw 20, the LED display module 1000 temporarily fixed by the adjustment screw 20 moves in the front-back direction, so that a level difference in the front-back direction between display surfaces of the LED display modules 1000 can be adjusted.

As described above, the first magnet coupling is formed to generate the rotational force of the adjustment screw 20 to thereby enable adjustment only by an access from the side of the display surface of the LED display module 1000. Sensitivity of adjustment herein depends on a thread pitch of the threaded portion 22.

A magnetic force of the first magnet coupling formed by the adjustment magnet 92 and the adjustment screw magnet 24 is equal to or greater than a magnetic force that can generate a force of attraction strong enough to be able to rotate the threaded portion 22.

After the location of the display surface of the LED display module 1000 in the front-back direction is adjusted, a fixing tool 80 of the video display device 100 is used to permanently fix the LED display module 1000 to the housing frame 5.

The fixing tool 80 has a similar configuration to the adjustment tool 90, and includes a fixing magnet 82 as a fourth magnet. The fixing magnet 82 and the fixing screw magnet 111 oppose each other to allow a magnetic force to act to attract each other to form a second magnet coupling. The fixing magnet 82 is rotated in a rotational direction of the fixing screw 11 in a state of the fixing magnet 82 attracting the fixing screw magnet 111 to generate a tightening force of the fixing screw 11 to close the slit 17 to thereby reduce the inside diameter of the through hole 13. The non-threaded portion 21 of the adjustment screw 20 is thereby tightened by the circumferential wall of the through hole 13, the adjustment screw 20 is fixed to the fixing slit collar 10, and the LED display module 1000 is permanently fixed to the housing frame 5.

The circumferential wall of the through hole 13 tightens the non-threaded portion 21 of the adjustment screw 20 to regulate rotation of the adjustment screw 20 to thereby suppress movement of the adjustment screw 20 relative to the housing frame 5, that is to say, movement of the display surface of the LED display module 1000 in the front-back direction.

A magnetic force of the second magnet coupling formed by the fixing magnet 82 and the fixing screw magnet 111a is herein a magnetic force that can generate a force of attraction strong enough to be able to rotate the fixing magnet 82 and to close the slit 17.

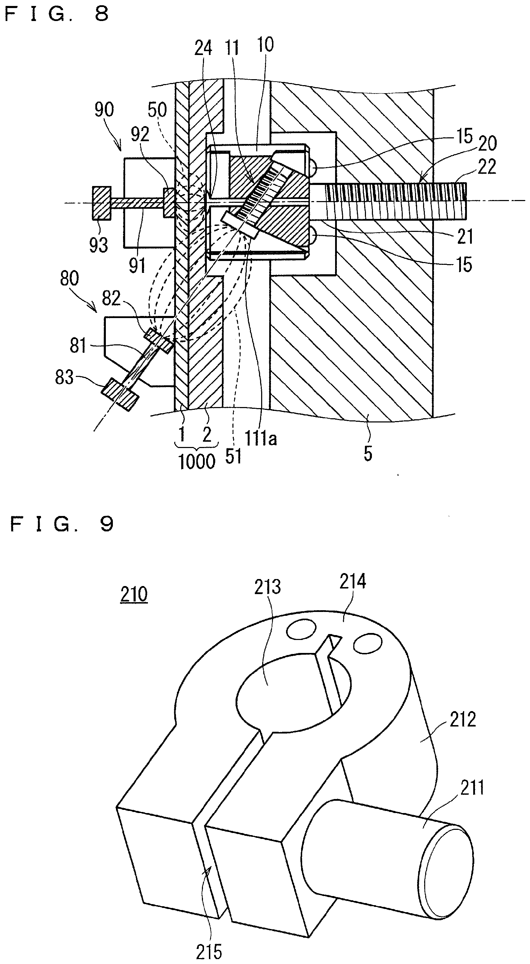

FIG. 8 is a sectional view for explaining magnetic fields acting when the location of the LED display module 1000 in the front-back direction is adjusted and fixed.

Broken lines in FIG. 8 represent an adjustment magnetic field 50 produced between the adjustment screw magnet 24 and the adjustment magnet 92 and a fixing magnetic field 51 produced between the fixing screw magnet 111a and the fixing magnet 82.

As illustrated in FIG. 8, the fixing screw 11 is disposed to have an inclination axis having an inclination angle with respect to the rotational axis of the adjustment screw 20. A rotational axis of the fixing screw 11 is an inclination axis inclined at 30° with respect to the rotational axis of the adjustment screw 20. A magnetic field expands around the rotational axis in each of the magnet couplings. The inclination angle prevents the magnetic field in the second magnet coupling from interfering with the magnetic field in the first magnet coupling, and mitigates the effect of the fixing magnet 82 on the adjustment screw magnet 24. The inclination angle and the distance are set not to cause interference of the magnetic force of the second magnet coupling with the adjustment screw magnet 24 and rotation of the adjustment screw 20 during fixing, and are changed depending on a selected magnet.

As described above, in the video display device 100 in Embodiment 1, the adjustment unit includes the adjustment screw 20 including: the non-threaded portion 21 on the side of the LED display module 1000; the threaded portion 22 to be screwed into the housing frame 5; and the adjustment screw magnet 24 disposed at the end portion of the non-threaded portion 21 on the side of the LED display module 1000 and having the plurality of magnetic poles different in the rotational direction, the fixing unit is fixed to the LED display module 1000 and includes: the cylindrical part 12 having the through hole 13 into which the non-threaded portion 21 of the adjustment screw 20 is to be inserted and the slit 17 to be closed to reduce the inside diameter of the through hole 13 so that the non-threaded portion 21 is tightened by the through hole 13; and the fixing screw 11 closing the slit 17 to fix the location of the adjustment screw 20 in the front-back direction, and the adjustment unit and the fixing unit are coaxially arranged.

Thus, a level difference between display surfaces of the video display device 100 can be suppressed, and detachment of the LED display module 1000 from the housing frame 5 can be suppressed.

Adjustment can be made again by the adjustment unit when the LED display module 1000 is replaced. Since the adjustment unit and the fixing unit are coaxially arranged, after the location of the LED display module 1000 in the front-back direction is adjusted, a shift of the adjusted location can be suppressed in a case where the LED display module 1000 is fixed to thereby suppress deflection of the LED display module 1000.

The fixing screw 11 includes the threaded portion 112, the head 111, and the fixing screw magnet 111a disposed on the head 111 and having the plurality of magnetic poles different in the rotational direction of the fixing screw 11, and the fixing screw 11 is disposed to have the inclination axis having the inclination angle with respect to the rotational axis of the adjustment screw 20 so that the rotational axis of the fixing screw 11 is not coaxial with the rotational axis of the adjustment screw 20 and the fixing screw 11 has a distance not causing the adjustment screw magnet 24 to be affected by the magnetic force generated by the fixing screw magnet 111a.

Thus, erroneous rotation of the adjustment screw 20 caused by interference of the magnetic force of the second magnet coupling with the adjustment screw magnet 24 can be suppressed during fixing of the LED display module 1000.

The video display device 100 further includes the adjustment tool 90 including the adjustment magnet 92, the adjustment screw 20 is brought into contact with the back surface of the LED display module 1000 by the magnetic force of the adjustment screw magnet 24, in a state of the adjustment tool 90 being brought into contact with the display surface of the LED display module 1000, the adjustment screw magnet 24 is attracted by the adjustment magnet 92 by the magnetic force of the adjustment magnet 92, and the adjustment magnet 92 is rotated to rotate the adjustment screw 20 to thereby adjust the distance between the LED display module 1000 and the housing frame 5.

Thus, the adjustment tool 90 can be used to adjust the distance between the LED display module 1000 and the housing frame 5 from the side of the display surface of the LED display module 1000. This can eliminate the need for a maintenance space for a person to enter on a side of a back surface of the multi-display system 200 after installation of the multi-display system 200 to reduce an installation space.

The multi-display system 200 further includes the fixing tool 80 including the fixing magnet 82, the fixing unit temporarily fixes the adjustment screw 20 in a state of the slit 17 being open, in a state of the fixing tool 80 being brought into contact with the display surface of the LED display module 1000, the fixing screw magnet 111a of the fixing screw 11 is attracted by the fixing magnet 82 by the magnetic force of the fixing magnet 82, and the fixing magnet 82 is rotated to rotate the fixing screw 11 to close the slit 17 to thereby fix the location of the adjustment screw 20 in the front-back direction.

Thus, the fixing tool 80 can be used to fix the location of the adjustment screw 20 in the front-back direction from the side of the display surface of the LED display module 1000. This can eliminate the need for the maintenance space for the person to enter on the side of the back surface of the multi-display system 200 after installation of the multi-display system 200 to reduce the installation space.

### <Embodiment 2>

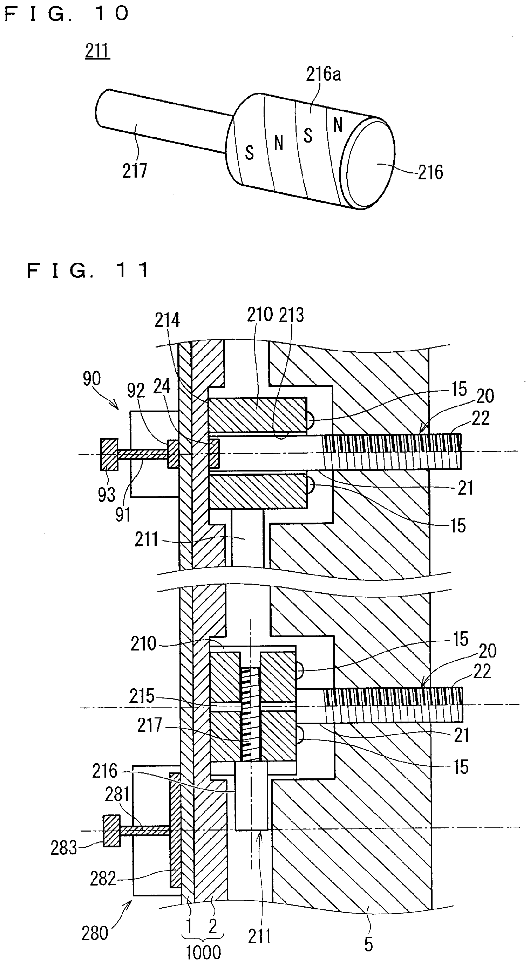

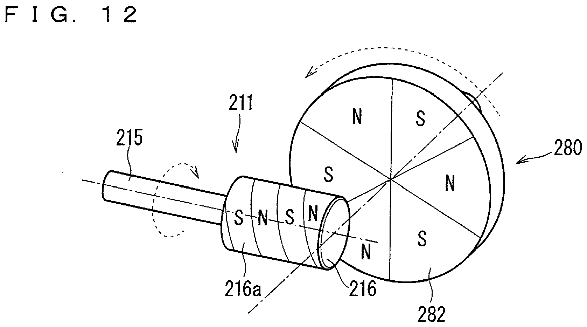

The multi-display system 200 according to Embodiment 2 will be described next. FIG. 9 is a perspective view illustrating a configuration of a fixing slit collar 210 of the video display device 100 according to Embodiment 2. FIG. 10 is a perspective view illustrating a configuration of a fixing screw 211 of the fixing slit collar 210. FIG. 11 is a sectional view for explaining a method of adjusting and fixing the location of the LED display module 1000 of the video display device 100 in the front-back direction. FIG. 12 illustrates a configuration of a magnet coupling formed by a fixing screw magnet 216 of a fixing tool 280 and a fixing magnet 282 of a fixing screw 215 of the video display device 100. In Embodiment 2, the same components as those described in Embodiment 1 bear the same reference signs as those in Embodiment 1, and description thereof is omitted.

As illustrated in FIG. 9, in Embodiment 2, the multi-display system 200 includes the fixing tool 280 in place of the fixing tool 80, and the video display device 100 includes the fixing slit collar 210 in place of the fixing slit collar 10.

The fixing slit collar 210 includes a cylindrical part 212 and a fixing screw 211. The cylindrical part 212 is substantially Ω-shaped when viewed from a contact surface 214 as a front surface thereof, and has a slit 215 between two leading end portions. The fixing screw 211 is mounted to cross the slit 215 from a side surface of one of the leading end portions to a side surface of the other one of the leading end portions.

The cylindrical part 212 has a through hole 213 extending in a direction of extension. The fixing slit collar 210 is attached in advance to the mold base 2 so that the through hole 213 is coaxial with the adjustment screw 20. The through hole 213 has an inside diameter slightly greater than the outside diameter of the adjustment screw 20, so that the adjustment screw 20 can slide inside the through hole 213 in the direction of extension of the cylindrical part 212, that is to say, in the front-back direction.

The fixing screw 211 of the fixing slit collar 210 is rotated forward to close the slit 215 to thereby reduce the inside diameter of the through hole 213. The through hole 213 having the reduced inside diameter tightens the adjustment screw 20 to fix the adjustment screw 20 to the fixing slit collar 210.

The front surface of the cylindrical part 212 has the mounting surface 214, and the mounting surface 214 is brought into contact with the back surface of the mold base 2 in advance. The fixing slit collar 210 is fixed to the mold base 2 by the screws 15 (see FIG. 11) in a state of the mounting surface 214 being brought into contact with the mold base 2. The fixing slit collar 210 may be adhesively fixed or press fitted to the mold base 2 instead of being fixed by the screws.

As illustrated in FIG. 10, the fixing screw 211 includes a head 111, a threaded portion 217 for closing the slit 215, and a fixing screw magnet 216a as a sixth magnet. The fixing screw magnet 216a is disposed on a side surface of the head 216, and has a plurality of different magnetic poles helically extending around a rotational axis of the fixing screw 211.

A method of fixing the location of the LED display module 1000 in the front-back direction will be described next. As illustrated in FIG. 11, after the location of the LED display module 1000 in the front-back direction is adjusted by a similar method to that in a case of Embodiment 1, the fixing tool 280 is used to permanently fix the LED display module 1000 to the housing frame 5.

The fixing tool 280 has a similar configuration to the adjustment tool 90, and includes a fixing magnet 282 as a fifth magnet. The fixing magnet 282 is a magnet in which a plurality of magnetic poles are arranged, and a fixing shaft 281 has a rotational axis orthogonal to the rotational axis of the fixing screw 211 to have a distance not causing the adjustment screw magnet 24 to be affected by a magnetic force generated by the fixing screw magnet 216a. The same magnetic poles of the fixing magnet 282 and the fixing screw magnet 216a attract each other. That is to say, the plurality of magnetic poles of the fixing magnet 282 and the same magnetic poles of the fixing screw magnet 216a as the plurality of magnetic poles of the fixing magnet 282 sequentially attract each other to form a third magnet coupling.

As illustrated in FIG. 12, since the fixing screw magnet 216a is helically disposed on a circumference of an axis of the fixing screw 211, the fixing screw magnet 216a is attracted by the fixing magnet 282 helically around the axis of the fixing screw 211, that is to say, to rotate the fixing screw 211. The fixing screw 211 is rotated forward to generate a tightening force of the fixing screw 211 to close the slit 215 to thereby reduce the inside diameter of the through hole 213. The non-threaded portion 21 of the adjustment screw 20 is thereby tightened by the circumferential wall of the through hole 213, the adjustment screw 20 is fixed to the fixing slit collar 210, and the LED display module 1000 is permanently fixed to the housing frame 5.

A magnetic force of the third magnet coupling formed by the fixing magnet 282 and the fixing screw magnet 216a is herein a magnetic force that can generate a force of attraction strong enough to be able to rotate the fixing screw magnet 216a and to close the slit 215.

Although the adjustment tool 90 and the fixing tool 280 are divided from each other in Embodiment 2, these tools may be integrated with each other as appropriate.

As described above, the video display device 100 according to Embodiment 2 further includes the fixing tool 280 including the fixing magnet 282, the fixing screw 211 includes the threaded portion 217, the head 216, and the fixing screw magnet 216a disposed on the head 216 and having the plurality of different magnetic poles helically extending around the rotational axis of the fixing screw 211, the fixing unit is disposed so that the fixing screw 211 has a rotational axis orthogonal to the rotational axis of the adjustment screw 20 to have a distance not causing the adjustment screw magnet 24 to be affected by the magnetic force generated by the fixing screw magnet 216a, the fixing unit temporarily fixes the adjustment screw 20 in a state of the slit 215 being open, in a state of the fixing tool 280 being brought into contact with the display surface of the LED display module 1000, the fixing screw magnet 216a of the fixing screw 211 is attracted by the fixing magnet 282 by the magnetic force of the fixing magnet 282, and the fixing magnet 282 is rotated to rotate the fixing screw 211 to close the slit 215 to thereby fix the location of the adjustment screw 20 in the front-back direction.

Thus, the fixing tool 280 can be used to fix the location of the adjustment screw 20 in the front-back direction from the side of the display surface of the LED display module 1000. This can eliminate the need for the maintenance space for the person to enter on the side of the back surface of the multi-display system 200 after installation of the multi-display system 200 to reduce the installation space.

While the present invention has been described in detail above, the foregoing description is in all aspects illustrative and does not restrict the present invention. It is understood that numerous modifications not having been described can be devised without departing from the scope of the present invention.

Embodiments of the present invention can freely be combined with each other, and can be modified or omitted as appropriate within the scope of the invention.

### Explanation of Reference Signs

5 housing frame, 11 fixing screw, 12 cylindrical part, 17 slit, 20 adjustment screw, 21 non-threaded portion, 22 threaded portion, 24 adjustment screw magnet, 80 fixing tool, 82 fixing magnet, 90 adjustment tool, 92 adjustment magnet, 100 to 106 video display device, 111 head, 111a fixing screw magnet, 112 threaded portion, 200 multi-display system, 211 fixing screw, 212 cylindrical part, 215 slit, 216 head, 216a fixing screw magnet, 217 threaded portion, 280 fixing tool, 282 fixing magnet, 1000 to 1004 LED display module.

## Claims

1. A video display device (100 to 106) comprising:
a video display module (1000 to 1004) in which display elements are arranged;
a housing frame (5) to which the video display module (1000 to 1004) is to be fixed;
an adjustment unit adjusting a location of the video display module (1000 to 1004) in a front-back direction in a state of the video display module (1000 to 1004) being temporarily fixed to the housing frame (5);
a fixing unit fixing, to the housing frame (5), the video display module (1000 to 1004) temporarily fixed to the housing frame (5), wherein
the adjustment unit includes an adjustment screw (20) including:
a non-threaded portion (21) on a side of the video display module (1000 to 1004);
a threaded portion (22) to be screwed into the housing frame (5); and
a first magnet (24) disposed at an end portion of the non-threaded portion (21) on the side of the video display module (1000 to 1004) and having a plurality of magnetic poles different in a rotational direction,
the fixing unit is fixed to the video display module (1000 to 1004),
the fixing unit includes:
a cylindrical part (12, 212) having:
a through hole (13, 213) into which the non-threaded portion (21) of the adjustment screw (20) is to be inserted; and
a slit (17, 215) to be closed to reduce an inside diameter of the through hole (13, 213) so that the non-threaded portion (21) is tightened by the through hole (13, 213); and
a fixing screw (11, 211) closing the slit (17, 215) to fix a location of the adjustment screw (20) in the front-back direction, and
the adjustment unit and the fixing unit are coaxially arranged.

2. The video display device (100 to 106) according to claim 1, wherein
the fixing screw (11) includes:
a threaded portion (112);
a head (111); and
a second magnet (111a) disposed on the head (111) and having a plurality of magnetic poles different in a rotational direction of the fixing screw (11), and
the fixing screw (11) is disposed to have a rotational axis that is an inclination axis having an inclination angle with respect to a rotational axis of the adjustment screw (20) so that the rotational axis of the fixing screw (11) is not coaxial with the rotational axis of the adjustment screw (20) and the fixing screw (11) has a distance not causing the first magnet (24) to be affected by a magnetic force generated by the second magnet (111a).

3. The video display device (100 to 106) according to claim 1, further comprising
an adjustment tool (90) including a third magnet (92), wherein
the adjustment screw (20) is brought into contact with a back surface of the video display module (1000 to 1004) by a magnetic force of the first magnet (24), and
in a state of the adjustment tool (90) being brought into contact with a display surface of the video display module (1000 to 1004), the first magnet (24) is attracted by the third magnet (92) by a magnetic force of the third magnet (92), and the third magnet (92) is rotated to rotate the adjustment screw (20) to thereby adjust a distance between the video display module (1000 to 1004) and the housing frame (5).

4. The video display device (100 to 106) according to claim 2, further comprising
a fixing tool (80) including a fourth magnet (82), wherein
the fixing unit temporarily fixes the adjustment screw (20) in a state of the slit (17) being open, and
in a state of the fixing tool (80) being brought into contact with a display surface of the video display module (1000 to 1004), the second magnet (111a) of the fixing screw (11) is attracted by the fourth magnet (82) by a magnetic force of the fourth magnet (82), and the fourth magnet (82) is rotated to rotate the fixing screw (11) to close the slit (17) to thereby fix the location of the adjustment screw (20) in the front-back direction.

5. The video display device (100 to 106) according to claim 1, further comprising
a fixing tool (280) including a fifth magnet (282), wherein
the fixing screw (211) includes:
a threaded portion (217);
a head (216); and
a sixth magnet (216a) disposed on the head (216) and having a plurality of different magnetic poles helically extending around a rotational axis of the fixing screw (211),
the fixing unit is disposed so that the fixing screw (211) has a rotational axis orthogonal to a rotational axis of the adjustment screw (20) to have a distance not causing the first magnet (24) to be affected by a magnetic force generated by the sixth magnet (216a),
the fixing unit temporarily fixes the adjustment screw (20) in a state of the slit (215) being open, and
in a state of the fixing tool (280) being brought into contact with a display surface of the video display module (1000 to 1004), the sixth magnet (216a) of the fixing screw (211) is attracted by the fifth magnet (282) by a magnetic force of the fifth magnet (282), and the fifth magnet (282) is rotated to rotate the fixing screw (211) to close the slit (215) to thereby fix the location of the adjustment screw (20) in the front-back direction.

6. A multi-display system (200) comprising
a plurality of the video display devices (100 to 106) according to any one of claims 1 to 5 combined with one another.
